# EUROPÄISCHE PATENTSCHRIFT

(11) **EP 3 748 827 B1**
(45) Veröffentlichungstag und Bekanntmachung des Hinweises auf die Patenterteilung: **24.07.2024**
(21) Anmeldenummer: 20175138.5
(22) Anmeldetag: 18.05.2020
(51) Int. Cl.: H02M 1/08, H02M 1/38, H03K 17/0416, H03K 17/16, H02M 7/5387, H02M 7/797, H02M 1/00

(54) **UMRICHTERHALBBRÜCKE MIT REDUZIERTER AUSSCHALTGATESPANNUNG WÄHREND DER TOTZEITEN**
CONVERTER HALF-BRIDGE WITH REDUCED TURN-OFF GATE VOLTAGE DURING DEAD TIMES
CONVERTISSEUR DEMI-PONT AVEC TENSION DE GRILLE REDUITE PENDANT LES TEMPS MORTS

(30) Priorität: 04.06.2019 DE 102019208122
(43) Veröffentlichungstag der Anmeldung: 09.12.2020
(73) Patentinhaber: Audi AG, 85045 Ingolstadt (DE)
(72) Erfinder: Apelsmeier, Andreas, 85131 Pollenfeld (DE)

(56) Entgegenhaltungen:
- EP-A1- 3 316 463
- DE-A1- 102013 214 224
- ZHANG BINFENG ET AL: "An improved gate driver based on magnetic coupling for crosstalk suppression of SiC devices", 2017 IEEE 3RD INTERNATIONAL FUTURE ENERGY ELECTRONICS CONFERENCE AND ECCE ASIA (IFEEC 2017 - ECCE ASIA), IEEE, 3 June 2017 (2017-06-03), pages 422 - 427, XP033129545, DOI: 10.1109/IFEEC.2017.7992075
- MARZ ANDREAS ET AL: "Comparison of SiC MOSFET gate-drive concepts to suppress parasitic turn-on in low inductance power modules", 2017 19TH EUROPEAN CONFERENCE ON POWER ELECTRONICS AND APPLICATIONS (EPE'17 ECCE EUROPE), JOINTLY OWNED IEEE-PELS AND EPE ASSOCIATION, 11 September 2017 (2017-09-11), XP033250426, DOI: 10.23919/EPE17ECCEEUROPE.2017.8099044

## Beschreibung

Die Erfindung betrifft ein Verfahren zum Betrieb einer wenigstens eine aus zwei Transistoren gebildete Halbbrücke umfassenden elektrischen Schaltung, wobei die elektrische Schaltung zwischen einem ersten Schaltzustand, in dem der erste Transistor der Halbbrücke durch einen ersten Spannungswert einer ersten Steuerspannung leitfähig geschaltet ist und der zweite Transistor der Halbbrücke durch einen zweiten Spannungswert einer zweiten Steuerspannung sperrend geschaltet ist, und einem zweiten Schaltzustand, in dem der erste Transistor durch einen zweiten Spannungswert der ersten Steuerspannung sperrend geschaltet ist und der zweite Transistor durch einen ersten Spannungswert der zweiten Steuerspannung leitfähig geschaltet ist, umgeschaltet wird, wobei zeitlich zwischen dem ersten Schaltzustand und dem zweiten Schaltzustand ein Totzeitzustand eingenommen wird, in dem beide Transistoren sperrend geschaltet sind.

Elektrische Schaltungen, welche wenigstens eine Halbbrücke aus zwei Transistoren umfassen, kommen in vielen Gebieten der Technik zum Einsatz. Beispielsweise können solche Schaltungen in Form von Halbleiterleistungsmodulen in einem Kraftfahrzeug eingesetzt werden, zum Beispiel als Wechselrichter. Diese Wechselrichter können beispielsweise als Traktionswechselrichter zum Betrieb eines Elektromotors über eine Batterie eingesetzt werden. Weitere Anwendungsmöglichkeiten derartiger Schaltungen bei Kraftfahrzeugen können im 12V Bereich die Lenkung oder die Getriebesteuerung sein. Auch eine Verwendung in elektrischen Klimakompressoren oder Gleichspannungswandlern ist bekannt.

Zum Schalten der Transistoren der Halbbrücke werden dabei Ansteuerungsschaltungen verwendet, über welche die Transistoren zwischen einem sperrenden und einem leitfähigen Zustand umgeschaltet werden können. Durch das Schalten der Transistoren entstehen Schaltverluste, welche einen signifikanten Anteil an der gesamten Verlustleistung der elektrischen Schaltung haben. Die Ansteuerung der Transistoren, bei denen es sich beispielsweise um MOSFETs oder IGBTs handeln kann, erfolgt in der Regel mittels separater, galvanisch getrennter Treiber für jeden der Transistoren. Aus dem Stand der Technik sind verschiedene Verfahren zum Betrieb von elektrischen Schalteranordnungen mit Transistoren und/oder Halbbrücken bekannt.

In WO 2006/037 670 A1 wird eine Schaltungsanordnung zum Ansteuern eines Piezoaktors mit einem von einer Bordnetzspannung eines Kraftfahrzeugs gespeisten Gleichspannungswandler beschrieben. Dabei werden ein High-Side-Schalttransistor und ein Low-Side-Schalttransistor über eine Treiberschaltung mittels eines Steuersignals geschaltet. Für die Ansteuerung des Piezoaktors werden die Schalttransistoren invers zueinander betrieben, so dass sie abwechselnd leitend geschaltet werden.

DE 10 2013 219 475 A1 beschreibt einen elektronischen Schaltkreis mit einem elektronischen Schalter und einem Überwachungsschaltkreis. Dabei ist der Überwachungsschaltkreis als ein Switched-Capacitor-Schaltkreis mit wenigstens einem kapazitiven Speicherelement ausgebildet und mit einer Laststrecke des elektronischen Schalters verbunden. Die Überwachungsschaltung wird dabei derart betrieben, dass durch sie eine Lastspannung des elektronischen Schalters ausgewertet und abhängig von der Auswertung ein Zählersignal erzeugt werden kann. Der Treiberschaltkreis des elektrischen Schalters wird derart betrieben, dass das an einem Steueranschluss des elektronischen Schalters bereitgestellte Treibersignal in Abhängigkeit von dem Zählersignal erzeugt wird.

Aus DE 10 2013 107 379 A1 ist eine Brückenschaltung aus integrierten Halbleiterbauelementen bekannt. Die Brückenschaltung umfasst dabei ein erstes integriertes Halbleiterbauelement als High-Side-Schalter sowie ein zweites integriertes Halbleiterbauelement als Low-Side-Schalter, welcher mit dem High-Side-Schalter elektrisch verbunden ist. Für jedes Halbleiterbauelement ist dabei ein Pegelwandler vorgesehen, wobei die Pegelwandler jeweils in einem der Halbleiterbauelemente integriert sind. Die Halbleiterbauelemente sind über die Pegelwandler mit einem Treiber verbunden, über welchen die Halbleiterbauelemente geschaltet werden.

DE 10 2016 223 312 A1 beschreibt eine Leistungshalbleiterbaugruppe für ein Kraftfahrzeug sowie ein Verfahren zum Betreiben dieser Leistungshalbleiterbaugruppe. Die Leistungshalbleiterbaugruppe umfasst einen Transistor sowie eine Treibereinrichtung, über welche ein zeitlicher Schaltspannungsverlauf zwischen einem Gateanschluss des Transistors und seinem Source- oder Emitteranschluss zum Schalten bereitgestellt wird. Der Gleichspannungsverlauf weist dabei einen Einschaltpuls, welcher der Einschaltphase des Transistors unmittelbar vorangeht und dessen Spannung größer als die Einschaltspannung ist, und/oder einen Ausschaltpuls, welcher unmittelbar an die Einschaltphase anschließt und dessen Spannung kleiner als die Ausschaltspannung ist, auf.

In dem Artikel "An improved gate driver based on magnetic coupling for crosstalk suppression of SiC devices" (Zhang et al., 2017 IEEE 3rd International Future Energy Electronics Conference And ECCE ASIA (IFEEC 2017 - ECCE ASIA), IEEE, 3. Juni 2017, S. 422 - 427) wird ein Verfahren zur Vermeidung von Crosstalk zwischen den Transistoren einer Halbbrücke beschrieben, um ein unbeabsichtigtes Wiedereinschalten des sperrenden Transistors zu vermeiden. Dabei wird in einer Totzeit zwischen den Schaltzyklen der Transistoren die Gate-Source-Spannung des im nachfolgenden Zustand sperrenden Transistors auf ein betragsmäßig größeres Sperrspannungsniveau gesetzt. Weiterhin wird die Spannung des in der nachfolgenden Phase leitfähig geschalteten Transistors von dem normalen Sperrspannungsniveau auf ein höheres Durchlassniveau gesetzt.

DE 10 2013 214 224 A1 beschreibt einen Leistungswandler mit einer zwei Transistoren umfassenden Halbbrückenschaltung sowie ein Verfahren zum Betrieb des Leistungswandlers. Dabei erfolgt ein Vorladen des Low-Side-Transistors der Halbbrücke durch eine Aufnahme der von der Gate-Source-Kapazität des High-Side-Transistors abgegebenen Ladung. Dazu sind die Gate-Anschlüsse der Transistoren der Halbbrücke über ein Schaltelement miteinander verbunden.

EP 3 316 463 A1 betrifft ein Verfahren zum Ändern eines Schaltzustands einer Halbbrückenschaltung, welche zwei Feldeffekttransistoren umfasst. Zur Vermeidung von parasitärem Wiedereinschalten des in einer nachfolgenden Schaltphase sperrenden Transistors wird dieser während einer Totzeit sowie während eines Zeitabschnitts nach Einschalten des anderen Transistors auf ein betragsmäßig höheres Sperrspannungsniveau gesetzt, so dass ein kapazitiver Ausgleichsstrom zwischen den Transistoren nicht zu einem unbeabsichtigten Wiedereinschalten des in der nachfolgenden Schaltphase sperrend geschalteten Transistors führt.

In dem Artikel "Comparison of SiC MOSFET gate-drive concepts to suppress parasitic turn-on in low inductance power modules" (März et al., 2017 19th European Conference on Power Electronics and Applications (EPE'17 ECCE Europe), 11. September 2017, S. P.1-P.10) wird ein Verfahren zum Betreiben einer zwei Transistoren umfassenden Halbbrücke beschrieben, um das parasitäre Wiedereinschalten eines sperrend geschalteten Transistors zu verhindern. Dazu wird in einer Totzeit zwischen zwei Schaltzuständen der Halbbrücke die Gate-Spannung des im nachfolgenden Zustand sperrend geschalteten Transistors auf ein betragsmäßig größeres Sperrspannungsniveau gesetzt.

Der Erfindung liegt die Aufgabe zugrunde, ein Verfahren zum Betrieb einer wenigstens eine aus zwei Transistoren gebildete Halbbrücke umfassenden elektrischen Schaltung anzugeben, welches die Schaltverluste in wenigstens einem der Transistoren im Betrieb der elektrischen Schaltung reduziert.

Die Aufgabe wird durch ein Verfahren nach Anspruch 1 gelöst.

Die Halbbrücke umfasst zwei elektrisch miteinander verbundene Feldeffekttransistoren.

Bei der Verwendung von Feldeffekttransistoren ist dabei der Sourcekontakt des ersten Transistors mit dem Drainkontakt des zweiten Transistors verbunden. Durch ein Schalten der Transistoren zwischen dem ersten Schaltzustand und dem zweiten Schaltzustand kann ein Schaltungsknoten zwischen den beiden Transistoren, welcher auch als Brückenpunkt oder Mittelpunkt der Halbbrücke bezeichnet wird, in seinem Potential verändert werden. Bei der Verwendung von zwei Feldeffekttransistoren kann dabei beispielsweise im ersten Schaltzustand der Brückenpunkt auf ein am Drainkontakt des ersten Transistors anliegendes erstes Potential eingestellt werden, indem der erste Transistor leitfähig und der zweite Transistor sperrend geschaltet wird. Umgekehrt kann der Brückenpunkt im zweiten Schaltzustand auch auf ein zweites, am Sourcekontakt des zweiten Transistors anliegendes Potential eingestellt werden, in dem der zweite Transistor leitfähig und der erste Transistor sperrend geschaltet wird.

Zwischen dem ersten Schaltzustand, in dem der erste Transistor leitfähig und der zweite Transistor sperrend geschaltet ist, und dem zweiten Schaltungszustand, in dem der erste Transistor sperrend und der zweite Transistor leitfähig geschaltet ist, ist ein Totzeitzustand vorgesehen, in welchem beide Transistoren sperrend geschaltet sind. Ein derartiger Totzeitzustand dient der Sicherheit des Betriebes der Halbbrücke bzw. der elektrischen Schaltung, da ein unerwünschter Zustand, in dem sowohl der erste Transistor als auch der zweite Transistor leitfähig geschaltet sind, auf diese Weise effizient vermieden werden können. Der erste Schaltzustand und der zweite Schaltzustand können insbesondere abwechselnd eingenommen werden, wobei jeweils zwischen den Schaltzuständen ein Totzeitzustand vorgesehen ist.

Das Schalten bzw. die Steuerung des ersten Transistors erfolgt durch die erste Steuerspannung, wobei bei einem ersten Spannungswert der ersten Steuerspannung der erste Transistor leitfähig geschaltet ist und bei einem zweiten Spannungswert der ersten Steuerspannung der erste Transistor sperrend geschaltet wird. Bei der Verwendung eines Feldeffekttransistors entspricht die Steuerspannung der Gate-Source-Spannung, wobei der erste Spannungswert einer Durchlassspannung entspricht, bei welcher der erste Transistor bzw. die Drain-Source-Strecke des ersten Transistors leitfähig ist, und der zweite Spannungswert entsprechend einer Sperrspannung entspricht, bei welcher der erste Transistor bzw. die Drain-Source-Strecke des ersten Transistors nicht leitfähig ist. Dies gilt entsprechend auch für den zweiten Transistor, welcher durch die zweite Steuerspannung geschaltet bzw. gesteuert wird. Der erste Spannungswert der ersten Steuerspannung kann gleich dem ersten Spannungswert der zweiten Steuerspannung sein und/oder der zweite Spannungswert der ersten Steuerspannung kann gleich dem zweiten Spannungswert der zweiten Steuerspannung sein.

Durch das Einstellen der Steuerspannung eines der Transistoren in dem Totzeitzustand auf einen Spannungszwischenwert, welcher zwischen dem ersten Spannungswert und dem zweiten Spannungswert der jeweiligen Steuerspannung des Transistors liegt, kann erreicht werden, dass bei einem dem Totzeitzustand nachfolgenden Schaltzustand, in dem einer der beiden Transistoren leitfähig geschaltet wird, dieser eine erhöhte Steilheit während des Schaltvorgangs, also eine schnellere Änderung des Stromes während des Schaltvorgangs, aufweist. Diese erhöhte Steilheit des leitfähig geschalteten Transistors ist dabei auf die in dem Totzeitzustand auf den Spannungszwischenwert eingestellte Steuerspannung des anderen, nicht leitfähig geschalteten, also sperrend betriebenen Transistors zurückzuführen. Mithin kann also im Totzeitzustand durch das Verändern der Steuerspannung des im nachfolgenden Zustands nicht leitfähig geschalteten Transistor die Schaltcharakteristik des dann leitfähig geschalteten Transistors verbessert werden. Diese verbesserte Schaltcharakteristik kann auf eine Veränderung der Kommutierungseigenschaften einer intrinsischen Diode des nicht geschalteten Transistors zurückgeführt werden. Diese Kommutierungseigenschaften sind von der an dem Transistor anliegenden Steuerspannung abhängig. Beim Schalten der Transistoren erfolgt eine Stromübernahme bei einer höheren Steuerspannung am nicht leitfähig geschalteten Transistor schneller als bei einer niedrigeren Steuerspannung. Bei einem normalen Schaltvorgang einer Halbbrücke kommutiert der Strom beispielsweise von einem einen High-Side-Transistor darstellenden ersten Transistor auf die Diode des einen Low-Side-Transistors darstellenden zweiten Transistors oder umgekehrt. Aufgrund der veränderbaren Kommutierungseigenschaften kann daher durch die Steuerspannung des jeweils nicht geschalteten Transistors Einfluss auf den Schaltvorgang des geschalteten Transistors genommen werden.

Eine erhöhte Steilheit beim Schalten eines Transistors bewirkt eine Reduktion der Schaltverluste bei dem Schaltvorgang. Die Schaltverluste tragen in der Regel mit einem Anteil zwischen 20% und 50% zu den Gesamtverlusten während des Betriebes einer Halbbrücke bei. Durch die Reduktion der Schaltverluste kann beispielsweise die Abwärme der Schaltung verringert werden, wodurch der Kühlaufwand und/oder die zur Kühlung erforderliche Fläche von als Halbleiterbauteile realisierten Transistoren reduziert werden kann. Weiterhin kann durch die reduzierten Schaltverluste bei einem die elektrische Schaltung umfassenden Kraftfahrzeug eine Reichweite bei elektrischem Fahrbetrieb erhöht bzw. die zum Erzielen einer Reichweite notwendige Batteriekapazität reduziert werden.

Der Spannungszwischenwert, auf den die Steuerspannung des wenigstens einen Transistor eingestellt wird, liegt zwischen dem ersten Spannungswert, welcher einer Durchlassspannung des Transistors entspricht, und dem zweiten Spannungswert, welcher einer Sperrspannung des Transistors entspricht. Der Spannungszwischenwert wird dabei derart ausgewählt, dass der Transistor weiterhin sperrt. Dies kann beispielsweise dadurch erreicht werden, dass für den zweiten Wert der Steuerspannung ein Wert gewählt wird, welcher deutlich unterhalb einer Schwellenspannung des Transistors liegt. Als Spannungszwischenwert kann dann ein Wert genommen werden, welcher zwar größer als der zweite Spannungswert, jedoch weiterhin kleiner als die Schwellenspannung des Transistors ist, so dass durch das Einstellen der Steuerspannung auf den Spannungszwischenwert kein Leitfähigschalten des Transistors erfolgt. Beispielsweise kann vorgesehen sein, dass der erste Spannungswert der Steuerspannung eines Transistors +15V beträgt, der zweite Spannungswert der Steuerspannung -4V und als Zwischenspannung ein Wert von -1V, 0V oder 1V gewählt wird. Diese Wert sind beispielhaft zu verstehen und richten sich nach den Charakteristiken des jeweils verwendeten Transistors. Es ist möglich, dass für die beiden Transistoren der wenigstens einen Halbbrücke der elektrischen Schaltung verschiedene oder baugleiche Transistoren verwendet werden. Auch können beide Transistoren demselben Typ, beispielsweise einem nMOS-Typ oder einem pMOS-Typ, entsprechen oder es kann sich um unterschiedliche Typen, insbesondere um komplementäre Typen von Transistoren, wie beispielsweise CMOS-Transistoren, handeln.

Erfindungsgemäß ist vorgesehen, dass in Abhängigkeit einer vorgegebenen oder gemessenen Stromrichtung eines am Mittelpunkt der Halbbrücke fließenden Laststromes ausgewählt wird, bei welchem der Transistoren die Steuerspannung in dem Totzeitzustand auf den Spannungszwischenwert eingestellt wird. Somit wird nur bei einem der beiden Transistoren in dem Totzeitzustand die Steuerspannung auf den Spannungszwischenwert eingestellt. Dies hat den Vorteil, dass der andere Transistor stets mit dem vollem Spannungshub, das heißt mit der vollen Differenz zwischen dem ersten Spannungswert und dem zweiten Spannungswert der Steuerspannung, geschaltet werden kann. Dieses Schalten mit dem vollen Spannungshub erhöht die Schaltgeschwindigkeit des Transistors und kann daher dazu genutzt werden, beispielsweise bei dem jeweils in Abhängigkeit der Stromrichtung des Laststromes stromführenden Transistor die auftretenden Schaltverluste zu reduzieren.

Die Stromrichtung bezieht sich auf die technische Stromrichtung des Laststroms, welcher von dem Mittelpunkt bzw. dem Brückenpunkt der Halbbrücke an eine an diesen Mittelpunkt angeschlossene Last fließt. Die Stromrichtung kann zum einen davon abhängen, zwischen welchen Potentialen der erste und der zweite Transistor, mithin also die Halbbrücke, angeordnet ist und welche Art von Last mit dem Laststrom gespeist wird. Bei der über den Laststrom gespeisten Last ist es insbesondere möglich, dass diese eine Induktivität aufweist, wie es beispielsweise bei Statorwicklungen einer Elektromaschine der Fall ist. Auch ist es möglich, dass ein Laststrom mit invertiertem Vorzeichen auftritt, wenn die Last auch zur Stromerzeugung eingesetzt werden kann. Dies kann beispielsweise bei einem über die wenigstens eine Halbbrücke umfassende elektrische Schaltung angesteuerten dreiphasigen Elektromotor der Fall sein, da über den Elektromotor in einem Generatorbetrieb ein Wechselstrom erzeugt und über die elektrische Schaltung in einen Gleichstrom gleichgerichtet werden kann. In diesem Fall kann insbesondere vorgesehen sein, dass die elektrische Schaltung zum Betrieb des dreiphasigen Elektromotors und/oder für die Gleichrichtung mehr als eine Halbbrücke umfasst. Zusätzlich oder alternativ kann beispielsweise eine sogenannte synchrone Gleichrichtung einer als bidirektionaler Wechselrichter betriebenen elektrischen Schaltung realisiert werden, bei welcher ein von der Last erzeugter negativer Laststrom anstatt über die intrinsische Diode eines Transistors durch den leitfähig geschalteten Kanal eines der Transistoren geführt wird. Es kann vorgesehen sein, dass während dieser synchronen Gleichrichtung eine andere Dauer des Totzeitzustandes als zwischen dem ersten Schaltzustand und dem zweiten Schaltzustand eingestellt wird.

Erfindungsgemäß ist vorgesehen, dass der erste Transistor mit einem ersten Potential verbunden ist und der zweite Transistor mit einem unterhalb des ersten Potential liegenden zweiten Potential verbunden ist, wobei bei positiver Stromrichtung des Laststromes in Bezug zu dem Mittelpunkt der Halbbrücke in dem Totzeitzustand der Spannungswert der zweiten Steuerspannung auf den Spannungszwischenwert eingestellt wird und bei negativer Stromrichtung des Laststromes in Bezug zu dem Mittelpunkt der Halbbrücke in dem Totzeitzustand der Spannungswert der ersten Steuerspannung auf den Spannungszwischenwert eingestellt wird. Bei dieser Anordnung stellt der erste Transistor einen High-Side-Transistor dar, bei welchem beispielsweise ein Drainkontakt mit dem ersten Potential verbunden ist. Das erste Potential kann ein positives Potential, beispielsweise von einer Batterie oder Ähnlichem, darstellen. Der Sourcekontakt des ersten Transistors ist in diesem Fall wie eingangs beschrieben mit dem Mittelpunkt der Halbbrücke und von dort beispielsweise mit einem Drainkontakt des zweiten Transistors, welcher einen Low-Side-Transistor darstellt, verbunden. Der Sourcekontakt des zweiten Transistors ist dabei mit dem zweiten Potential, welches geringer als das erste Potential ist, verbunden. Bei dem zweiten Potential kann es sich beispielsweise um ein negatives Batteriepotential oder um ein Massepotential der elektrischen Schaltung handeln. Durch das Einstellen der zweiten Steuerspannung des Low-Side-Transistors auf den Spannungszwischenwert bei Vorliegen einer in Bezug zu dem Mittelpunkt der Halbbrücke positiven Stromrichtung des Laststromes bzw. bei dem entsprechenden Einstellen der ersten Steuerspannung des ersten Transistors auf den Spannungszwischenwert bei Vorliegen einer in Bezug zu dem Mittelpunkt der Halbbrücke negativen Stromrichtung des Laststromes, kann erreicht werden, dass bei einem Betrieb der Last über den Laststrom der jeweils stromführende Transistor mit maximalem Spannungshub betrieben wird. Dadurch reduzieren sich vorteilhaft die Schaltverluste der elektrischen Schaltung.

Allgemein erfolgt die Berücksichtigung der Stromrichtung derart, dass bei dem jeweils nicht stromführenden Transistor die Steuerspannung auf den Spannungszwischenwert eingestellt wird, so dass der jeweils stromführende Transistor mit maximalem Spannungshub betrieben wird und die Schaltverluste somit vorteilhaft reduziert werden können.

Erfindungsgemäß kann vorgesehen sein, dass die Stromrichtung des Laststromes durch einen Stromsensor der elektrischen Schaltung und/oder aus wenigstens einem wenigstens einem der Transistoren zugeordneten Halbleitersensor und/oder anhand eines in einer Recheneinrichtung der elektrischen Schaltung hinterlegten Modells bestimmt wird. Der Stromsensor zur Messung der Stromrichtung des Laststromes kann beispielsweise zwischen den Mittelpunkt der Halbbrücke und einer mit dem Laststrom gespeisten Last geschaltet sein. Zusätzlich oder alternativ dazu ist es möglich, eine Stromrichtung des Laststromes mittels eines Halbleitersensors zu bestimmen, welcher wenigstens einem der Transistoren zugeordnet ist. Durch diesen Halbleitersensor kann beispielsweise das Schaltverhalten des Transistors bestimmt und/oder ausgewertet werden. Der Halbleitersensor kann beispielsweise Bestandteil einer dem Transistor zugeordneten Treiberschaltung sein. Es ist auch möglich, dass die Stromrichtung mittels eines in einer Recheneinrichtung der elektrischen Schaltung hinterlegten Modells bestimmt wird. Die Recheneinrichtung kann dabei verschiedene Parameter der elektrischen Schaltung auslesen und anhand eines in einer Speichereinrichtung der Recheneinrichtung gespeicherten Modells eine Stromrichtung ermitteln.

Erfindungsgemäß kann vorgesehen sein, dass eine elektrische Schaltung mit wenigstens einer Steuerungseinrichtung verwendet wird, wobei die Steuerungseinrichtung zum Erzeugen der ersten Steuerspannung und/oder der zweiten Steuerspannung ausgebildet ist. Es ist beispielsweise möglich, dass für die beiden Transistoren der wenigstens einen Halbbrücke jeweils eine Steuerungseinrichtung vorhanden ist. Es ist auch möglich, dass für weitere Transistoren, welche beispielsweise weitere Halbbrücken bilden, ebenfalls jeweils eine Steuerungseinrichtung verwendet wird. Es ist auch möglich, dass eine Steuerungseinrichtung zur Erzeugung der ersten Steuerspannung und der zweiten Steuerspannung und/oder gegebenenfalls weiterer Steuerspannungen von weiteren Transistoren ausgebildet ist.

Durch die wenigstens eine Steuerungseinrichtung können die an dem ersten Transistor und an dem zweiten Transistor anliegenden erste Steuerspannung und zweite Steuerspannung jeweils wenigstens auf den ersten Spannungswert, den zweiten Spannungswert und den Spannungszwischenwert eingestellt werden. Die Steuerungseinrichtung kann auch als Treiberschaltung des Transistors bzw. der Transistoren bezeichnet werden. Die wenigstens eine Steuerungseinrichtung kann zur stromrichtungsabhängigen Ansteuerung der Transistoren mit einem Stromsensor und/oder dem wenigstens einen Halbleitersensor verbunden sein oder diese umfassen. Es ist auch möglich, dass die Steuerungseinrichtung eine Recheneinrichtung umfasst oder mit einer solchen verbunden ist, so dass eine Ansteuerung der Transistoren auf Grundlage eines in der Recheneinrichtung hinterlegten Modells ermöglicht wird.

In einer bevorzugten Ausgestaltung der Erfindung kann vorgesehen sein, dass als Feldeffekttransitoren MOSFETs aus Siliziumcarbit, verwendet werden. Als Feldeffekttransistoren können dabei neben MOSFETs auch weitere Arten von Feldeffekttransistoren wie Sperrschichtfeldeffekttransistoren oder Ähnliches verwendet werden. Bei der Verwendung von Feldeffekttransistoren als erster Transistor und als zweiter Transistor der wenigstens einen Halbbrücke kann aufgrund der bei diesem Transistortyp ausgebildeten intrinsischen Diode die größte Verringerung von Schaltverlusten erzielt werden. Die Verwendung von Transistoren aus Siliziumcarbit ermöglicht höhere Schaltgeschwindigkeiten der Transistoren und somit auch der Halbbrücke bzw. der elektrischen Schaltung, so dass das erfindungsgemäße Verfahren mit besonderem Vorteil eingesetzt werden kann.

Erfindungsgemäß kann vorgesehen sein, dass als elektrische Schaltung ein, insbesondere dreiphasiger und insbesondere bidirektional betreibbarer, Wechselrichter verwendet wird. Es ist auch möglich, dass es sich bei der elektrischen Schaltung um eine Vollbrücke, insbesondere um eine Vollbrücke in einem Gleichspannungswandler, handelt. Es ist möglich, dass die elektrische Schaltung als dreiphasiger Pulswechselrichter ausgebildet ist. Auch eine Ausbildung der Schaltung als einphasiger, zweiphasiger oder mehr als dreiphasiger Wechselrichter ist möglich. Bei Vorhandensein mehrerer Halbbrücken in der elektrischen Schaltung kann insbesondere jede der Halbbrücken mit dem erfindungsgemäßen Verfahren betrieben werden. Ein Umschalten des ersten Schaltzustandes und des zweiten Schaltzustandes der elektrischen Schaltung kann beispielsweise mit einer Frequenz zwischen 5 kHz und 30 kHz, insbesondere zwischen 10 kHz und 20 kHz, erfolgen.

Für eine erfindungsgemäße elektrische Schaltung gemäß Anspruch 6 ist vorgesehen, dass diese wenigstens eine aus zwei Feldeffekttransistoren gebildete Halbbrücke sowie wenigstens eine Steuerungseinrichtung umfasst, wobei die Steuerungseinrichtung zum Betrieb der elektrischen Schaltung nach einem der vorangehenden Verfahren ausgebildet ist. Die Steuerungseinrichtung kann dabei insbesondere als Treiberschaltung der Feldeffekttransistoren der wenigstens einen Halbbrücke ausgebildet sein oder eine derartige Treiberschaltung umfassen bzw. mit einer derartigen Schaltung verbunden sein, so dass über die Steuerungseinrichtung eine Einstellung der ersten Steuerspannung und der zweiten Steuerspannung möglich ist.

Sämtliche vorangehend in Bezug zu dem erfindungsgemäßen Verfahren beschriebene Vorteile und Einzelheiten gelten entsprechend für die erfindungsgemäße elektrische Schaltung.

Für ein erfindungsgemäßes Kraftfahrzeug gemäß Anspruch 7 ist vorgesehen, dass dieses eine erfindungsgemäße elektrische Schaltung umfasst. Die elektrische Schaltung kann dabei beispielsweise einen Traktionswechselrichter darstellen, über welchen ein von einer Batterie bereitgestellter Gleichstrom in einen Wechselstrom, insbesondere einen dreiphasigen Wechselstrom, zum Betrieb einer elektrischen Maschine des Kraftfahrzeugs gewandelt wird. Der Wechselrichter kann dabei in einem bidirektionalen Betrieb auch als Gleichrichter arbeiten und einen von der elektrischen Maschine in einem generatorischen Betrieb erzeugten Wechselstrom in einen Gleichstrom zum Wiederaufladen der Batterie wandeln. Es ist auch möglich, dass es sich bei der elektrischen Schaltung um einen aus einem 12V-Bordnetz gespeisten Wechselrichter des Kraftfahrzeugs, um einen Bestandteil eines elektrischen Klimakompressors oder um einen Gleichspannungswandler handelt.

Sämtliche in Bezug zu der erfindungsgemäßen elektrischen Schaltung bzw. zu dem erfindungsgemäßen elektrischen Verfahren beschriebenen Vorteile und Einzelheiten gelten entsprechend auch für das erfindungsgemäße Kraftfahrzeug.

Weitere Vorteile und Einzelheiten der Erfindung ergeben sich aus den nachfolgend dargestellten Ausführungsbeispielen sowie anhand der Zeichnungen.

Diese sind schematische Darstellungen und zeigen:
- Fig. 1: eine Ausführungsbeispiel der erfindungsgemäßen Schaltungsanordnung,
- Fig. 2: eine schematische Darstellung einer Treiberschaltung eines Transistors gemäß Stand der Technik,
- Fig. 3: ein Diagramm, welches Spannungsverläufe beim Ansteuern einer Halbbrücke gemäß dem Stand der Technik zeigt,
- Fig. 4: ein Diagramm, welches den Betrieb einer Halbbrücke gemäß einem Beispiel eines nicht erfindungsgemäßen Verfahrens darstellt,
- Fig. 5: ein erstes Diagramm, welches den Einfluss einer auf einen Spannungszwischenwert eingestellten Steuerungsspannung auf einen Einschaltvorgang eines Transistors darstellt,
- Fig. 6: ein zweites Diagramm, welches den Einfluss einer auf den Spannungszwischenwert eingestellten Steuerungsspannung auf einen Einschaltvorgang eines Transistors darstellt,
- Fig. 7: ein erstes Diagramm, welches den Verlauf von einer ersten und einer zweiten Steuerspannung nach einem Ausführungsbeispiel des erfindungsgemäßen Verfahrens zum Betrieb einer Halbbrücke darstellt,
- Fig. 8: ein zweites Diagramm, welches den Verlauf von einer ersten und einer zweiten Steuerspannung nach dem Ausführungsbeispiel des erfindungsgemäßen Verfahrens zum Betrieb einer Halbbrücke darstellt,
- Fig. 9: ein Beispiel einer Treiberschaltung, welche das Einstellen eines Spannungszwischenwertes ermöglicht, und
- Fig. 10: ein erfindungsgemäßes Kraftfahrzeug.

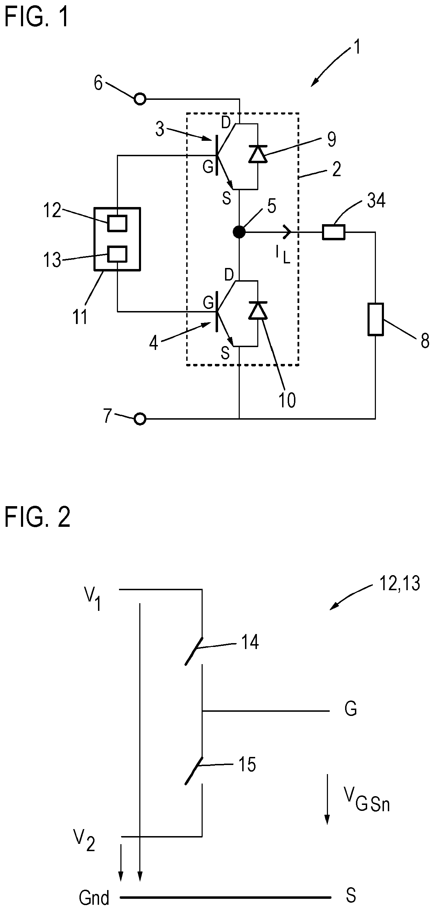

In Fig. 1 ist eine schematische Darstellung einer erfindungsgemäßen elektrischen Schaltung 1 gezeigt. Die elektrische Schaltung 1 umfasst eine Halbbrücke 2, welche durch einen ersten Transistor 3 und einen zweiten Transistor 4 gebildet ist. Der erste Transistor 3 stellt dabei den High-Side-Transistor der Halbbrücke 2 und der zweite Transistor 4 den Low-Side-Transistor der Halbbrücke 2 dar.

Der erste Transistor 3 und der zweite Transistor 4 sind beispielsweise als auf Siliziumcarbit basierende MOSFET-Transistoren ausgebildet. Der erste Transistor 3 ist mit dem zweiten Transistor 4 über einen Mittelpunkt 5 der Halbbrücke 2, welcher auch als Brückenpunkt bezeichnet werden kann, verbunden. Dabei ist der Sourcekontakt des ersten Transistors 3 mit dem Mittelpunkt 5 der Halbbrücke 2 und dem Drainkontakt des zweiten Transistors 4 verbunden. Der Drainkontakt des ersten Transistors 3 ist mit einem ersten Potential 6 verbunden. Der Sourcekontakt des zweiten Transistors 4 ist mit einem zweiten Potential 7, welches niedriger als das erste Potential 6 ist, verbunden. Bei dem ersten Potential 6 kann es sich um ein positives Potential handeln und bei dem zweiten Potential 7 beispielsweise um ein Massepotential. Zwischen den Mittelpunkt 5 der Halbbrücke 2 und das zweite Potential 2 ist eine Last 8, hier dargestellt durch einen Lastwiderstand R_{L}, geschaltet. Die Last 8 kann zusätzlich oder alternativ zu einem elektrischen Widerstand auch eine Induktivität und/oder eine Kapazität umfassen. Die elektrische Schaltung 1 umfasst einen Stromsensor 34, über welchen die Richtung eines zwischen dem Mittelpunkt 5 und der Last 8 fließenden Laststromes I_{L} bestimmt werden kann.

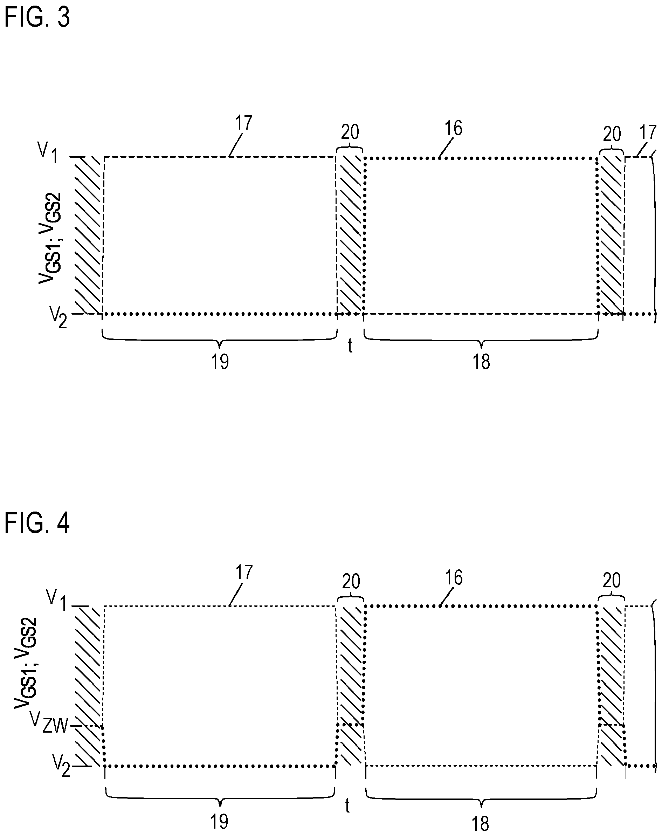

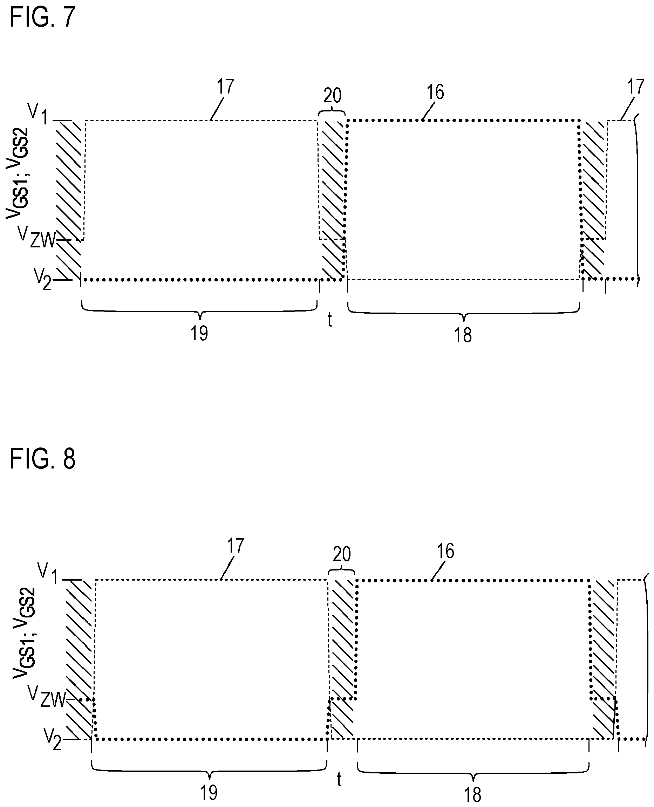

Der erste Transistor 3 und der zweite Transistor 4 umfassen jeweils eine intrinsische Diode 9 bzw. 10. Weiterhin sind der erste Transistor 3 und der zweite Transistor 4 mit einer Steuerungseinrichtung 11 der elektrischen Schaltung 1 verbunden. Die Steuerungseinrichtung 11 umfasst zwei galvanisch getrennte Treiberschaltungen 12, 13, wobei die Treiberschaltung 12 mit dem Gateanschluss des ersten Transistors 3 und die Treiberschaltung 13 mit dem Gateanschluss des zweiten Transistors 4 verbunden ist. Über die Treiberschaltung 12 wird eine erste Steuerspannung erzeugt, welche als Gate-Source-Spannung V_{GS1} des ersten Transistors 3 zum Sperren bzw. zum leitfähig Schalten des ersten Transistors 3 dient. Entsprechend erzeugt die Treiberschaltung 13 eine Gate-Source-Spannung V_{GS2} des zweiten Transistors 4, welche zum Sperren bzw. zum leitfähig Schalten des zweiten Transistors 4 eingesetzt wird. Die Steuereinrichtung 11 ist zum Betrieb des ersten Transistors 3 und des zweiten Transistors 4 gemäß Fig. 4, Fig. 7 und/oder Fig. 8 eingerichtet.

In Fig. 2 ist eine schematische Darstellung einer Treiberschaltung 12, 13 gemäß dem Stand der Technik dargestellt. Die Treiberschaltung umfasst dabei zwei Schalter 14, 15, mittels welcher die an dem Gateanschluss des an die Treiberschaltung 12, 13 angeschlossenen Transistors anliegende Gate-Source-Spannung V_{GSn} auf einen ersten Spannungswert V₁ oder einen zweiten Spannungswert V₂ geschaltet werden kann. Dabei stellt der erste Spannungswert V₁ eine Durchlassspannung dar, bei der der jeweils mit der Treiberschaltung 12, 13 verbundene Transistor leitfähig geschaltet wird. Der zweite Spannungswert V₂ stellt eine Sperrspannung dar, mit welcher der mit der Treiberschaltung 12, 13 verbundene Transistor gesperrt werden kann. Mittels zweier derartiger Treiberschaltungen 12, 13 könnte die in Fig. 1 dargestellte Halbbrücke 2 in aus dem Stand der Technik bekannter Weise betrieben werden. Diesen Betrieb zeigt Fig. 3.

In Fig. 3 ist die Gate-Source-Spannung V_{GS1} des ersten Transistors 3 als erste Kurve 16 und die Gate-Source-Spannung V_{GS2} des zweiten Transistors 4 als zweite Kurve 17, jeweils über der Zeit aufgetragen, dargestellt. Dabei kann zwischen einem ersten Schaltzustand, in dem der erste Transistor 3 leitfähig geschaltet und der zweite Transistor 4 sperrend geschaltet ist, sowie einem zweiten Schaltzustand, in dem der zweite Transistor 4 leitfähig und der erste Transistor 3 sperrend geschaltet ist, unterschieden werden. Der erste Schaltzustand liegt bei der Darstellung in Fig. 3 in einem Bereich 18 und der zweite Schaltzustand in einem Bereich 19 vor. Der erste Schaltzustand und der zweite Schaltzustand können sich dabei beispielsweise im Zeitverlauf abwechseln.

Zwischen dem ersten Schaltzustand und dem zweiten Schaltzustand ist ein im schraffiert dargestellten Bereich 20 liegender Totzeitzustand vorgesehen, in dem sowohl der erste Transistor 3 als auch der zweite Transistor 4 sperrend geschaltet sind. Dieser Totzeitzustand dient der Sicherheit der elektrischen Schaltung, da ein unerwünschter Betriebszustand, in dem beide Transistoren leitfähig geschalten sind, auf diese Weise effektiv vermieden werden kann. Ersichtlich wird der erste Transistor 3 bzw. der zweite Transistor 4 leitfähig geschaltet, indem die jeweilige Gate-Source-Spannung des Transistors V_{GS1} bzw. V_{GS2} von dem zweiten Spannungswert V₂ auf den ersten Spannungswert V₁ umgeschaltet wird. Im vorliegend gezeigten Beispiel handelt es sich bei dem ersten Spannungswert V₁ um einen positiven Spannungswert und bei dem zweiten Spannungswert V₂ um einen negativen, das heißt unterhalb eines Massepotentials liegenden Spannungswert.

In Fig. 4 ist ein Diagramm dargestellt, welches einen Betrieb der elektrischen Schaltung 1 gemäß einem Beispiel eines nicht erfindungsgemäßen Verfahrens zeigt. In diesem Beispiel werden sowohl die die erste Steuerspannung darstellende Gate-Source-Spannung V_{GS1} des ersten Transistors sowie die die zweite Steuerspannung des zweiten Transistors 4 darstellende Gate-Source-Spannung V_{GS2} während des Totzeitzustands auf einen Spannungszwischenwert Vzw eingestellt. Dieser Spannungszwischenwert Vzw liegt zwischen dem ersten Spannungswert V₁ und dem zweiten Spannungswert V₂. Es ist beispielsweise möglich, dass der erste Spannungswert V₁ +15V und der zweite Spannungswert V₂ -4V beträgt. Als Spannungszwischenwert Vzw kann dabei beispielsweise ein Wert von -1V, 0V oder 1V gewählt werden. Es ist auch möglich, dass ein anderer Zwischenwert innerhalb des Intervalls zwischen dem ersten Spannungswert V₁ und dem zweiten Spannungswert V₂ gewählt wird. Das Einstellen der ersten Steuerspannung und der zweiten Steuerspannung auf den Spannungszwischenwert hat den Vorteil, dass der Transistor, welcher jeweils in dem dem Totzeitzustand nachfolgenden Betriebszustand leitfähig geschaltet wird, eine erhöhte Steilheit während des Schaltvorgangs aufweist. Dadurch können die Schaltverluste beim Schalten des ersten Transistors 3 bzw. des zweiten Transistors 4 und somit auch der Halbbrücke 2 der elektrischen Schaltung 1 reduziert werden. Dieser Effekt wird anhand der nachfolgenden Diagramme weiter erläutert.

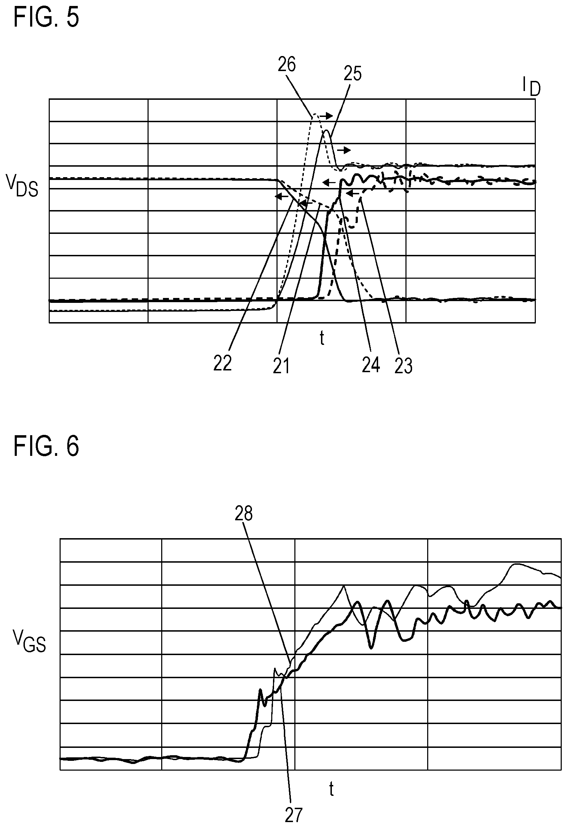

Fig. 5 zeigt ein Diagramm, in dem die Kurven 21 und 22 jeweils den Verlauf der Drain-Source-Spannung V_{DS} eines am Ende des Totzeitzustands leitfähig geschalteten Transistors einer Halbbrücke darstellen. Dabei entspricht die Kurve 21 dem Fall, in dem für den am Ende des Totzeitzustands nicht leitfähig geschalteten Transistor die jeweilige Steuerspannung während des Totzeitzustands auf dem zweiten Spannungswert verbleibt und die Kurve 22 den Fall, in dem die Steuerspannung des nicht leitfähig geschalteten Transistors während des Totzeitzustands auf einen Spannungszwischenwert eingestellt wird. Entsprechend zeigen die Kurven 23 und 24 die Drain-Source-Spannung V_{DS} des am Ende des Totzeitzustands nicht leitfähig geschalteten Transistors, wobei die Kurve 23 dem Fall entspricht, in dem die Steuerspannung des nicht leitfähig geschalteten Transistors auf den zweiten Spannungswert eingestellt ist und die Kurve 24 dem Fall entspricht, in dem die Steuerspannung des nicht leitfähig geschalteten Transistors auf den Spannungszwischenwert eingestellt wird.

Zusätzlich ist in den Kurven 25 und 26 jeweils der Drainstrom, welcher durch den leitfähig geschalteten Transistor fließt, dargestellt. Hierbei stellt die Kurve 25 den Drainstrom für den Fall dar, in dem die Steuerspannung des nicht leitfähig geschalteten Transistors auf dem zweiten Spannungswert eingestellt ist und die Kurve 26 entspricht dem Fall, in dem die Steuerspannung des nicht leitfähig geschalteten Transistors auf den Spannungszwischenwert eingestellt wird. Ersichtlich weist die Kurve 22 während des Einschaltvorgangs des Transistors eine größere Steigung auf als die Kurve 21. Ebenfalls weist die Kurve 26 während des Einschaltvorgangseine höhere Steigung auf als die Kurve 25. Erkennbar kann durch das Einstellen der Steuerspannung auf den Spannungszwischenwert die Schaltcharakteristik des geschalteten Transistors verbessert und dessen Schaltverluste somit vorteilhaft reduziert werden. Untersuchungen haben gezeigt, dass das Einstellen der Steuerspannung auf den Spannungszwischenwert bei dem Einschaltvorgang abhängig von einer Taktfrequenz des Halbbrücke 2 die Schaltverluste signifikant reduziert werden können.

In Fig. 6 ist der Verlauf der Gate-Source-Spannungen des geschalteten Transistors dargestellt. Dabei beschreibt Kurve 27 den Fall, in dem die Steuerspannung des nicht geschalteten Transistors auf den zweiten Spannungswert eingestellt ist und Kurve 28 den Fall, in dem die Steuerspannung des nicht geschalteten Transistors auf den Spannungszwischenwert eingestellt ist. Die in den Figuren 5 und 6 in den Kurven 21 bis 28 gezeigten Verläufe der jeweiligen Messgrößen beziehen sich auf den Einschaltvorgang eines Transistors. Untersuchungen haben gezeigt, dass das Einstellen der Steuerspannung auf den Spannungszwischenwert bei dem Ausschaltvorgang des Transistors ebenfalls einen positiven, verglichen mit dem Einschaltvorgang jedoch geringeren Effekt aufweist.

In Fig. 7 und Fig. 8 ist ein Betrieb einer Halbbrücke 2 gemäß eines Ausführungsbeispiels eines erfindungsgemäßen Verfahrens dargestellt. In diesem Ausführungsbeispiel wird anhand der Stromrichtung des Laststromes I_{L} in Bezug zu dem Mittelpunkt 5 der Halbbrücke 2 ausgewählt, bei welchem der beiden Transistoren 3, 4 die Steuerspannung auf den Spannungszwischenwert eingestellt wird. Dabei ist in Fig. 7 der Fall für einen positiven Laststrom und in Fig. 8 der Fall eines negativen Laststroms I_{L} dargestellt. Ersichtlich wird im Fall eines positiven Laststroms I_{L}, wie in Fig. 7 dargestellt, die in Kurve 17 aufgetragene Steuerspannung V_{GS2} des zweiten Transistors 4 in dem im Bereich 20 liegenden Totzeitzustand auf dem Spannungszwischenwert Vzw eingestellt. Die Steuerspannung V_{GS1} des ersten Transistors 3, welche in Kurve 16 aufgetragen ist, verbleibt in diesem Totzeitzustand auf dem zweiten Spannungswert V2.

Wie in Fig. 8 dargestellt ist, wird umgekehrt im Fall eines negativen Laststromes I_{L} in Bezug zu dem Mittelpunkt 5 der Halbbrücke 2 die in Kurve 16 aufgetragene erste Steuerspannung V_{GS1} des ersten Transistors 3 auf den Spannungszwischenwert Vzw eingestellt, wohingegen die zweite Steuerspannung V_{GS2} des zweiten Transistors 4 entsprechend Kurve 17 in dem Totzeitzustand auf dem zweiten Spannungswert V₂ verbleibt. Ein negativer Laststrom kann beispielsweise bei einer als bidirektional betreibbarer, mehrphasiger Wechselrichter ausgeführten elektrischen Schaltung 1, welche insbesondere mehrere Halbbrücken 2 umfassen kann, auftreten.

Die Berücksichtigung der Stromrichtung des Laststromes I_{L} ermöglicht, dass der jeweils stromführende Transistor, also in dem in Fig. 7 dargestellten Fall der den High-Side-Transistor der Halbbrücke 2 darstellende erste Transistor 3, bzw. im Fall des negativen Laststroms I_{L} gemäß Fig. 8 der den Low-Side-Transistor der Halbbrücke 2 darstellende zweite Transistor 4, mit dem maximalen Spannungshub zwischen dem ersten Spannungswert V₁ und dem zweiten Spannungswert V₂ geschaltet wird. Ein derartiges Schalten des ersten Transistors 3 bzw. des zweiten Transistors 4 ermöglicht ein schnelleres und somit schaltverlustärmeres Betreiben des jeweiligen Transistors.

Eine Bestimmung der Stromrichtung des Laststromes I_{L} kann beispielsweise durch den Stromsensor 34 der elektrischen Schaltung 1 vorgenommen werden, welcher die Stromrichtung des Laststromes I_{L} in Bezug zu dem Mittelpunkt 5 der Halbbrücke 2 bestimmt. Es ist auch möglich, dass eine Bestimmung der Stromrichtung des Laststromes I_{L} über wenigstens einen wenigstens einen der Transistoren 3, 4 zugeordneten Halbleitersensor erfolgt. Der wenigstens eine Halbleitersensor kann dabei beispielsweise ein Bestandteil der Steuerungseinrichtung 11 sein. Es ist zusätzlich oder alternativ auch möglich, dass eine Ermittlung der Stromrichtung des Laststromes I_{L} anhand eines in einer Recheneinrichtung der elektrischen Schaltung 1 hinterlegten Modells bestimmt wird. Die Recheneinrichtung der elektrischen Schaltung 1 kann dabei beispielsweise ein Bestandteil der Steuerungseinrichtung 11 sein, wobei die Steuereinrichtung 11 die Treiberschaltungen 12, 13 derart betreibt, dass diese jeweils eine unter Berücksichtigung des Modells ermittelte Steuerspannung erzeugen.

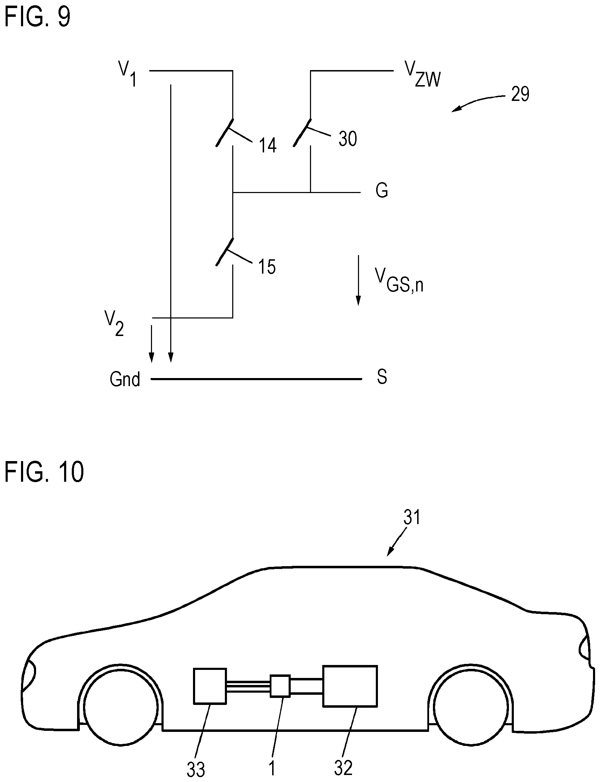

In Fig. 9 ist eine Treiberschaltung 29 dargestellt, welche das Einstellen der Steuerspannung eines angeschlossenen Transistors auf einen ersten Spannungswert V₁, einen zweiten Spannungswert V₂ sowie einen zwischen diesen beiden Spannungswerten liegenden Spannungszwischenwert Vzw ermöglicht. Die Treiberschaltung 29 umfasst dazu drei Schalter 14, 15 und 30, mittels welcher die von der Treiberschaltung 29 erzeugte Steuerspannung, welche eine Gate-Source-Spannung V_{GSn} des angeschlossenen Transistors darstellen kann, erzeugt werden kann. Es ist insbesondere auch möglich, dass der Spannungszwischenwert V_{ZW} dem Massepotential GND entspricht, wobei in diesem Fall vorgesehen sein kann, dass der Schalter 29 zwischen einem Gateanschluss G des Transistors und dem Massepotential GND angeordnet ist.

Eine erfindungsgemäße Schaltung 1 kann mehr als eine Halbbrücke 2 aufweisen. Dabei kann insbesondere vorgesehen sein, dass jede Halbbrücke 2 der elektrischen Schaltung 1 gemäß einem Ausführungsbeispiel eines erfindungsgemäßen Verfahrens angesteuert wird. Dazu kann beispielsweise die Steuerungseinrichtung 11 weitere Treiberschaltungen 12, 13 umfassen, welche jeweils mit dem ersten Transistor und dem zweiten Transistor einer weiteren Halbbrücke verbunden ist. Es ist auch möglich, dass für jede der Halbbrücken eine eigene Steuerungseinrichtung 11 vorhanden ist. Eine mehrere Halbbrücken 2 umfassende elektrische Schaltung 1 kann beispielsweise als dreiphasiger Pulswechselrichter realisiert und insbesondere bidirektional betreibbar sein.

Fig. 10 zeigt ein erfindungsgemäßes Kraftfahrzeug 31, welches eine erfindungsgemäße elektrische Schaltung 1 umfasst. Die elektrische Schaltung 1 ist dabei als ein dreiphasiger Traktionswechselrichter ausgeführt und wird dazu verwendet, einen von einer Batterie 32 des Kraftfahrzeugs 31 erzeugten Gleichstrom in einen dreiphasigen Wechselstrom zum Betrieb einer Elektromaschine 33 des Kraftfahrzeugs 32 zu wandeln. Es kann insbesondere vorgesehen sein, dass die elektrische Schaltung 1 zu einem bidirektionalen Betrieb ausgebildet ist, so dass auch eine Gleichrichtung eines von der elektrischen Maschine 33 in einem generatorischen Betrieb erzeugten Wechselstroms in einen Gleichstrom zum Laden der Batterie 32 möglich ist. Zusätzlich oder alternativ kann das Kraftfahrzeug 31 wenigstens eine weitere elektrische Schaltung 1 umfassen, bei der es sich beispielsweise um einen aus einem 12V-Bordnetz gespeisten Wechselrichter des Kraftfahrzeugs 31, um einen Bestandteil eines elektrischen Klimakompressors und/oder um einen Gleichspannungswandler handelt.

## Patentansprüche

1. Verfahren zum Betrieb einer wenigstens eine aus zwei Transistoren (3, 4) gebildete Halbbrücke (2) umfassenden elektrischen Schaltung (1), wobei als Transistoren (3, 4) Feldeffekttransistoren verwendet werden, wobei die elektrische Schaltung (1) zwischen einem ersten Schaltzustand, in dem der erste Transistor (3) der Halbbrücke (2) durch einen ersten Spannungswert einer ersten Steuerspannung leitfähig geschaltet ist und der zweite Transistor (4) der Halbbrücke (2) durch einen zweiten Spannungswert einer zweiten Steuerspannung sperrend geschaltet ist, und einem zweiten Schaltzustand, in dem der erste Transistor (3) durch einen zweiten Spannungswert der ersten Steuerspannung sperrend geschaltet ist und der zweite Transistor (4) durch einen ersten Spannungswert der zweiten Steuerspannung leitfähig geschaltet ist, umgeschaltet wird, wobei zeitlich zwischen dem ersten Schaltzustand und dem zweiten Schaltzustand ein Totzeitzustand eingenommen wird, in dem beide Transistoren (3, 4) sperrend geschaltet sind, wobei in dem Totzeitzustand die Steuerspannung eines der Transistoren (3, 4) auf einen Spannungszwischenwert, welcher zwischen dem ersten Spannungswert und dem zweiten Spannungswert der Steuerspannung des Transistors (3, 4) liegt, eingestellt wird,
wobei der erste Transistor (3) mit einem ersten Potential verbunden ist und der zweite Transistor (4) mit einem unterhalb des ersten Potential liegenden zweite Potential verbunden ist,
**dadurch gekennzeichnet,**
**dass** in Abhängigkeit einer vorgegebenen oder gemessenen Stromrichtung eines am Mittelpunkt (5) der Halbbrücke (2) fließenden Laststromes ausgewählt wird, bei welchem der Transistoren (3, 4) die Steuerspannung in dem Totzeitzustand auf den Spannungszwischenwert eingestellt wird, wobei bei positiver Stromrichtung des Laststromes in Bezug zu dem Mittelpunkt (5) der Halbbrücke (2) in dem Totzeitzustand der Spannungswert der zweiten Steuerspannung auf den Spannungszwischenwert eingestellt wird, und wobei bei negativer Stromrichtung des Laststromes in Bezug zu dem Mittelpunkt (5) der Halbbrücke (2) in dem Totzeitzustand der Spannungswert der ersten Steuerspannung auf den Spannungszwischenwert eingestellt wird, und wobei sich die Stromrichtung auf die technische Stromrichtung des Laststroms bezieht, welcher von dem Mittelpunkt der Halbbrücke an eine an diesen Mittelpunkt angeschlossene Last fließt.

2. Verfahren nach Anspruch 1,
**dadurch gekennzeichnet,**
**dass** die Stromrichtung des Laststromes durch einen Stromsensor der elektrischen Schaltung (1) und/oder aus wenigstens einem wenigstens einem der Transistoren (3, 4) zugeordneten Halbleitersensor und/oder anhand eines in einer Recheneinrichtung der elektrischen Schaltung (1) hinterlegten Modells bestimmt wird.

3. Verfahren nach einem der vorangehenden Ansprüche,
**dadurch gekennzeichnet,**
**dass** eine elektrische Schaltung (1) mit wenigstens einer Steuerungseinrichtung (11) verwendet wird, wobei die Steuerungseinrichtung (11) zum Erzeugen der ersten Steuerspannung und/oder der zweiten Steuerspannung ausgebildet ist.

4. Verfahren nach einem der vorangehenden Ansprüche,
**dadurch gekennzeichnet,**
**dass** als Transistoren (3, 4) MOSFETs aus Siliziumcarbid verwendet werden.

5. Verfahren nach einem der vorangehenden Ansprüche,
**dadurch gekennzeichnet,**
**dass** als elektrische Schaltung (1) ein, insbesondere dreiphasiger und insbesondere bidirektional betreibbarer, Wechselrichter verwendet wird.

6. Elektrische Schaltung, umfassend wenigstens eine aus zwei Transistoren (3, 4) gebildete Halbbrücke (2) sowie wenigstens eine Steuerungseinrichtung (11), wobei die Steuerungseinrichtung (11) zum Betrieb der elektrischen Schaltung (1) nach einem der vorangehenden Ansprüche ausgebildet ist.

7. Kraftfahrzeug, umfassend eine elektrische Schaltung (1) nach Anspruch 6.

## Claims

1. Method for operating an electrical circuit (1) comprising at least one half-bridge (2) formed from two transistors (3, 4), wherein field-effect transistors are used as transistors (3, 4), wherein the electrical circuit (1) is switched between a first switching state in which the first transistor (3) of the half-bridge (2) is switched to conductive by a first voltage value of a first control voltage, and the second transistor (4) of the half-bridge (2) is switched to blocking by a second voltage value of a second control voltage, and a second switching state in which the first transistor (3) is switched to blocking by a second voltage value of the first control voltage and the second transistor (4) is switched to conductive by a first voltage value of the second control voltage, wherein a dead time state in which both transistors (3, 4) are switched to blocking is assumed chronologically between the first switching state and the second switching state, wherein, in the dead time state, the control voltage of one of the transistors (3, 4) is set to an intermediate voltage value which is between the first voltage value and the second voltage value of the control voltage of the transistor (3, 4),
wherein the first transistor (3) is connected to a first potential and the second transistor (4) is connected to a second potential lying below the first potential, **characterised in that**, depending on a predetermined or measured current direction of a load current flowing at the centre point (5) of the half-bridge (2), the transistor (3, 4) is selected at which the control voltage in the dead time state is set to the intermediate voltage value, wherein in the dead time state when the current direction of the load current is positive in relation to the centre point (5) of the half-bridge (2), the voltage value of the second control voltage is set to the intermediate voltage value, and wherein in the dead time state when the current direction of the load current is negative in relation to the centre point (5) of the half-bridge (2), the voltage value of the first control voltage is set to the intermediate voltage value, and wherein the current direction refers to the technical current direction of the load current which flows from the centre point of the half-bridge to a load connected to this centre point.

2. Method according to claim 1,
**characterised in that**
the current direction of the load current is determined by a current sensor of the electrical circuit (1) and/or from at least one semiconductor sensor associated with at least one of the transistors (3, 4) and/or based on a model stored in a computing apparatus of the electrical circuit (1).

3. Method according to any one of the preceding claims,
**characterised in that**
an electrical circuit (1) with at least one control apparatus (11) is used, wherein the control apparatus (11) is configured to generate the first control voltage and/or the second control voltage.

4. Method according to any one of the preceding claims,
**characterised in that**
silicon carbide MOSFETs are used as transistors (3, 4).

5. Method according to any one of the preceding claims, **characterised in that** an inverter is used as electrical circuit (1), in particular a three-phase and in particular bidirectionally operable inverter.

6. Electrical circuit comprising at least one half-bridge (2) formed from two transistors (3, 4) and at least one control apparatus (11), wherein the control apparatus (11) is configured to operate the electrical circuit (1) according to any one of the preceding claims.

7. Motor vehicle comprising an electrical circuit (1) according to claim 6.

## Revendications

1. Procédé de fonctionnement d'un circuit électrique (1) comprenant au moins un demi-pont (2) formé à partir de deux transistors (3, 4), dans lequel des transistors à effet de champ sont utilisés comme transistors (3, 4), dans lequel le circuit électrique (1) est commuté entre un premier état de commutation, dans lequel le premier transistor (3) du demi-pont (2) est monté de manière à être conducteur par une première valeur de tension d'une première tension de commande et le second transistor (4) du demi-pont (2) est monté de manière à être bloquant par une seconde valeur de tension de la seconde tension de commande, et un second état de commutation dans lequel le premier transistor (3) est commuté de manière à être bloquant par une seconde valeur de tension de la première tension de commande et le second transistor (4) est commuté de manière à être conducteur par une première valeur de tension de la seconde tension de commande, dans lequel un état de temps mort est adopté chronologiquement entre le premier état de commutation et le second état de commutation, état dans lequel les deux transistors (3, 4) sont commutés de manière à être bloquants, dans lequel, à l'état de temps mort, la tension de commande d'un des transistors (3, 4) est réglée sur une valeur intermédiaire de tension qui se situe entre la première valeur de tension et la seconde valeur de tension de la tension de commande du transistor (3, 4),
dans lequel le premier transistor (3) est relié à un premier potentiel et le second transistor (4) est relié à un second potentiel inférieur au premier potentiel, **caractérisé en ce qu'**en fonction d'un sens du courant prédéfini ou mesuré d'un courant de charge circulant au niveau du point central (5) du demi-pont (2), le transistor (3, 4) auquel la tension de commande est réglée à l'état de temps mort sur la valeur intermédiaire de tension est sélectionné, dans lequel, en cas de sens du courant positif du courant de charge par rapport au point central (5) du demi-pont (2) à l'état de temps mort, la valeur de tension de la seconde tension de commande est réglée sur la valeur intermédiaire de tension, et dans lequel, en cas de sens du courant négatif du courant de charge par rapport au point central (5) du demi-pont (2) à l'état de temps mort, la valeur de tension de la première tension de commande est réglée sur la valeur intermédiaire de tension, et dans lequel le sens du courant fait référence au sens du courant technique du courant de charge qui circule du point central du demi-pont vers une charge raccordée audit point central.

2. Procédé selon la revendication 1,
**caractérisé en ce que**
le sens du courant du courant de charge est déterminé par un capteur de courant du circuit électrique (1) et/ou à partir d'au moins un capteur à semi-conducteur associé à au moins un des transistors (3, 4) et/ou à l'aide d'un modèle stocké dans un appareil de calcul du circuit électrique (1).

3. Procédé selon l'une quelconque des revendications précédentes,
**caractérisé en ce que**
un circuit électrique (1) est utilisé avec au moins un appareil de commande (11), dans lequel l'appareil de commande (11) est conçu pour générer la première tension de commande et/ou la seconde tension de commande.

4. Procédé selon l'une quelconque des revendications précédentes,
**caractérisé en ce que**
des MOSFET en carbure de silicium sont utilisés comme transistors (3, 4).

5. Procédé selon l'une quelconque des revendications précédentes, **caractérisé en ce qu'**un onduleur, en particulier triphasé et pouvant fonctionner en particulier de manière bidirectionnelle, est utilisé.

6. Circuit électrique comprenant au moins un demi-pont (2) formé à partir de deux transistors (3, 4), ainsi qu'au moins un appareil de commande (11), dans lequel l'appareil de commande (11) est conçu pour le fonctionnement du circuit électrique (1) selon l'une quelconque des revendications précédentes.

7. Véhicule à moteur, comprenant un circuit électrique (1) selon la revendication 6.
